# EUROPEAN PATENT APPLICATION

(11) **EP 1 202 345 A2**
(43) Date of publication of application: **02.05.2002**
(21) Application number: 01125817.5
(22) Date of filing: 29.10.2001
(51) Int. Cl.: H01L 23/373

(54) **Semiconductor power element heat dissipation board, conductor plate therefor, heat sink material and solder material**

(30) Priority: 31.10.2000 JP 2000332347; 09.02.2001 JP 2001033342
(71) Applicant: Hitachi, Ltd., Chiyoda-ku, Tokyo 101-8010 (JP); Hitachi Cable, Ltd., Tokyo 100-8166 (JP)
(72) Inventor: Suzuki, Seikou, Hitachiota-shi, Ibaraki 313-0016 (JP); Kondo, Yasuo, Hitachinaka-shi, Ibaraki 312-0055 (JP); Abe, Teruyoshi, Hitachi-shi, Ibaraki 319-1225 (JP); Watanabe, Noriyuki, Hitachinaka-shi, Ibaraki 312-0001 (JP); Suzumura, Takashi, Matsushiro Residence, Tsukuba-shi, Ibaraki 305-0035 (JP); Nakagawa, Kazuhiko, Niihari-gun, Ibaraki 300-4111 (JP)
(74) Representative: Strehl Schübel-Hopf & Partner

(57) **Abstract**

An object of the present invention is to provide a semiconductor power element heat dissipation board which has a high bonding strength without voids in the bonding portion, and has high reliability without forming a thick brittle Al/Cu intermetallic chemical compound, and of which the manufacturing method is simple, and to provide a conductor plate and a heat sink plate and a solder used for the semiconductor power element heat dissipation board, and to provide a power module and a composite plate using the semiconductor power element heat dissipation board.

The present invention relates to a semiconductor power element heat dissipation board having a structure formed by bonding laminated bodies of a conductor plate 6, a ceramic plate 3 and a heat sink plate 1 using an aluminum alloy group solder 2, 4 of a clad type, and the semiconductor power element heat dissipation board is characterized by that the bonding strengths between the conductor plate and the ceramic plate and between the ceramic plate and the heat sink plate are above several tens MPa, and by that the semiconductor power element heat dissipation board has a diffusion suppression member for preventing or suppressing diffusion to aluminum in the solder, and by that the plates are bonded by any one of or combination of a composite solder having an aluminum alloy group solder on a core member made of aluminum or an aluminum alloy and a low temperature melting point aluminum solder. The present invention also relates to a conductor plate and a heat sink plate for the semiconductor power element heat dissipation board, and to a power module and a composite plate using the semiconductor power element heat dissipation board.

## Description

### BACKGROUND OF THE INVENTION

The present invention relates to a novel power module mounting semiconductor power elements, and to a novel heat dissipation board used for the power module, and to a conductor plate and a heat sink and a solder material and a composite plate used for the heat dissipation board.

Heat dissipation boards for semiconductor power element having a structure of laminating a conductor plate, a ceramic plate and a heat sink plate have been known. Various kinds of materials are used for the conductor plate, the ceramic plate and the heat sink plate, and various methods are used for bonding between the conductor plate and the ceramic plate and between the ceramic plate and the heat sink plate. For example, heat dissipation boards using an aluminum alloy group solder for bonding are disclosed in Japanese Patent Application Laid-Open No.3-125463, Japanese Patent Application Laid-Open No.4-12554, Japanese Patent Application Laid-Open No.9-27572, Japanese Patent Application Laid-Open No.10-65075, Japanese Patent Application Laid-Open No.11-220073 and Japanese Patent Application Laid-Open No.2000-119071.

The following are problems in the semiconductor power element heat dissipation board formed by bonding the plates using the aluminum alloy group solder while adding a load (0.1 to 10 MPa) under a high temperature condition (about 580 to 610 °C) in a vacuum atmosphere or an inert atmosphere.
(a) The conductor plate may be bonded to the load adding jig or may be contaminated by the load adding jig. Particularly, the phenomena frequently appeared when the conductor plate is made of aluminum, an aluminum alloy, copper or a copper alloy.
(b) A constituent of the conductor plate and the heat sink plate diffuses into aluminum in the aluminum alloy group solder material (for example, an Al-Si alloy, an Al-Si-Mg alloy, an Al-Ge alloy, an Al-Si-Ge alloy and so on) to form chemical compounds of aluminum and the elements composing the conductor plate and the heat sink plate. The bonding strength of the bonding portion was decreased by presence of the chemical compound layer to cause a problem in the reliability. Particularly, when the conductor plate and the heat sink plate were made of copper group materials, the above problem frequently occurred because an eutectic reaction was caused between Al and Cu at 548 °C to form a thick and brittle layer made of an intermetallic compound of Al and Cu.
(c) A large amount of the melted solder of the aluminum alloy was made to flow out from the bonding portion to the external by adding of the load at bonding to produce large voids in the bonding portion or to cause a trouble of incapability of bonding in an extreme case. As the result, the bonding strength of the bonding portion was decreased, and the heat dissipation board could not be used under a severe thermal shock environment. Particularly, when the conductor plate and the heat sink plate were made of a material such as copper or a copper alloy, the problem frequently occurred because the eutectic temperature (melting temperature) of aluminum and copper was as low as 548 °C which was lower than the melting temperature of a well-known aluminum alloy group solder (for example, 578 °C in the case of the Al-12 weight % Si solder).
(d) The conductor plate and the aluminum alloy group solder (the solder was printed or was formed of a film) were different members from each other. Therefore, the manufacturing method was unsuitable for mass production because a problem of displacement occurred at laminating and number of the laminating processes was increased.
(e) The thermal expansion coefficients of the ceramic plate and the conductor plate were largely different from each other, and the temperature of bonding the conductor plate to the ceramic plate was as high as 580 °C. Therefore, a trouble such as separation or the like was apt to occur due to thermal stress produced in the bonding portion when the semiconductor power element heat dissipation board was used under a severe environment having a large number of thermal shocks. Particularly, the trouble frequently occurred when the conductor plate and the heat sink plate were made of a copper group material such as copper, a copper alloy, a copper composite material or the like. Further, the ceramic plate is made of alumina, aluminum nitride, silicon nitride or the like, and the thermal expansion coefficients of the materials are about 8 ppm/°C, 4 ppm/°C and 3 ppm/°C, respectively. On the other hand, when the conductor plate and the heat sink plate are made of copper or aluminum, the thermal expansion coefficients of the materials are about 17 ppm/°C and 24 ppm/°C, respectively.
(f) An electric short circuit sometimes occurred between the conductor plate and the heat sink plate by seeping of the melted aluminum alloy group solder due to adding of load at bonding to reduce the manufacturing yield.
(g) In addition to these, there was neither proposal nor verification of any aluminum alloy group solder having a melting point lower than 500 °C in order to perform bonding at a low temperature of 400 °C class suitable for the productivity.

As described above, the conventional heat dissipation boards for semiconductor power element have had the significant problems relating to the productivity and the reliability.

### SUMMARY OF THE INVENTION

An object of the present invention is to provide a semiconductor power element heat dissipation board which has a high bonding strength without voids in the bonding portion, and prevents forming of a brittle Al/Cu intermetallic chemical compound, and has high reliability, and of which the manufacturing method is simple, and to provide a conductor plate and a heat sink plate and a solder used for the semiconductor power element heat dissipation board, and to provide a power module and a composite plate using the semiconductor power element heat dissipation board.

The semiconductor power element heat dissipation board in accordance with the present invention has no void in the bonding portion and has a high bonding strength of at least 10 MPa or larger through bonding capable of suppressing aluminum diffusion by employing any one of or combination of providing a diffusion suppression member for suppressing diffusion of aluminum; using a low melting point aluminum alloy group solder; using an aluminum alloy group solder provided onto a core member or the conductor plate made of aluminum or an aluminum alloy; and pressing by adding a load at bonding. Further, as the result, it is possible to prevent forming of a brittle Al/Cu intermetallic chemical compound and to provide a semiconductor power element heat dissipation board high in reliability and easy in manufacturing, and to provide a conductor plate and a heat sink plate used for the semiconductor power element heat dissipation board .
(a) The manufacturing method employed was that the surface of the conductor plate in one side opposite to the surface in the other side to be in contact with the ceramic plate was plated with nickel, and the nickel surface was brought in contact with a surface of a load adding jig. The load adding jig was formed of a ceramic such as alumina or a high melting point metal or carbon. As the result, since nickel did not react with the ceramic or the high melting point metal or carbon, the nickel surface was not bonded to the load adding jig and was not contaminated by the jig.
(b) The diffusion suppression member for preventing diffusion of a constituent of the conductor plate to aluminum or suppressing the effect of diffusion of the constituent of the conductor plate to aluminum by being contacted with at least part of the conductor plate was provided. Otherwise, the film of the member capable of preventing diffusion of the constituent of the conductor plate to aluminum or suppressing the effect of diffusion of the constituent of the conductor plate to aluminum was formed on the surface of the heat sink plate. By doing so, it was possible to prevent the constituent of the conductor plate and the heat sink plate from diffusing (including dissolving) to aluminum in the aluminum alloy group solder, and accordingly it was possible to prevent forming of aluminum chemical compounds (when the conductor plate and the heat sink plate were made of a copper group material, the aluminum chemical compound was Al/Cu which decreased the bonding strength). As the result, the bonding strength of the bonding portion was increased to improve the reliability.
   Further, in a case where the heat sink plate is made of a copper composite material (Cu/Cu₂O) in which cuprous oxide (Cu₂O) was dispersed in copper (Cu), because part of the surface of the heat sink plate was converted to cuprous oxide difficult to react with aluminum, the formation of Al/Cu chemical compound could be prevented in a certain degree even if any film of a special diffusion suppression member for preventing diffusion to aluminum was not formed on the heat sink plate. In this case, the bonding strength of the bonding portion could be improved in a certain degree. However, in order to aiming perfection, it was preferable that a film of the above-mentioned member for preventing diffusion to aluminum or for suppressing the effect of diffusion to aluminum was formed on the surface of the heat sink plate.
   It is preferable that the heat sink plate described above is made of any one of copper, a copper alloy, a copper composite material, aluminum and an aluminum alloy, and that the a second heat sink plate made of aluminum or an aluminum alloy is bonded to the surface of the heat sink plate in one side opposite to the surface in the other side in contact with the above-mentioned ceramic plate using a solder or an aluminum alloy group solder.
   As the materials for preventing the diffusion to aluminum or for suppressing the effect of the diffusion to aluminum, pure Ni, pure Cr, pure Ti, Pure W, an Ni alloy, a Cr alloy, a Ti alloy, a W alloy and so on were effective. Evaluation was performed by selecting Ni group and Cr group materials from the stand point of film forming property such as plating and Ti group and W group materials from the stand point of high melting point property. Among these materials, the film thickness of pure Ni is preferably 5 to 20 µm, and the film thickness of the materials other than Ni is preferably 0.5 to 5 µm. Further, the high melting point materials are preferable as the materials for the diffusion suppression member, and particularly the higher melting point materials of pure Ni having the melting point above 1455 °C, pure Ti having the melting point above 1667 °C and pure Cr having the melting point above 1900 °C are preferable.
(c) A clad member was formed by pre-cladding a thin film of an aluminum alloy group solder portion on the one side surface or on the both side surfaces of a core material portion made of aluminum or an aluminum alloy was used. The aluminum alloy group solder portion is made of an Al base alloy such as an Al-Si alloy, an Al-Si-Mg alloy, an Al-Ge alloy or an Al-Si-Ge alloy. It is preferable that the Al base alloy contains Si of 5 to 15 wt% and Ge of 5 to 20 wt% and the total amount of the two kinds of 5 to 20 wt%. It is particularly preferable that the total amount of the two kinds is 5 to 15 wt%, and further preferable that the total amount of the two kinds is 8 to 13 wt%. It is preferable that the Al base alloy contains Mg less than 5 wt%. In the concrete, in a case where Al-12%Si alloy or Al-12%Si-1%Mg alloy is used for the solder, the eutectic temperature (melting temperature) of the solder is about 580 °C which is lower than the melting temperature 660 °C of the aluminum core member. As the result, even in the case where the conductor plate, the ceramic plate and the heat sink plate were laminated, and the laminated body was heated to a high temperature of 850 °C to 610 °C under a vacuum atmosphere or an inert atmosphere, and then a load of 0.1 to 10 MPa was added to the laminated body using a jig made of alumina to bond the plates, it was possible to prevent the melted aluminum alloy group solder from flowing out from the bonding portions to the external. Therefore, the troubles of forming voids in the bonding portion and incapability of bonding could be solved.
   The clad member formed of the laminated pieces of the solder portion/ the core material portion/ the solder portion was a film having a total thickness of one hundred to several hundreds µm, and it was possible to completely prevent the melted solder from flowing out from the bonding portion to the external by thinning the thickness of the solder portion to about 10 % of the thickness of the core member. As described above, the clad member formed of the laminated piece of the solder portion/ the core material portion/ the solder portion was extremely effective as an aluminum alloy group solder which could materialize a high reliable semiconductor power element heat dissipation board having a high bonding strength without no void in the bonding portion.
   When the thickness of the solder portion is as thin as below several tens µm, a certain intensity of bonding strength could be obtained without the core material portion though a very small amount of voids were formed. In that case, it was necessary that the bonding load per unit area was decreased as low as possible and the load adding time was lengthened. In that case, the speed of production will be somewhat decreased.
   In a case where the conductor plate and the heat sink plate were made of a copper group material such as copper, a copper alloy or a copper composite material, since the eutectic temperature (melting temperature) of the aluminum and copper was 548 °C which was lower than the melting temperature of the aluminum alloy group solder (for example, about 580 °C), the core material portion in the clad member reacted with copper to be melted under the above-mentioned bonding condition, and accordingly not only the solder portion but also the core material portion flowed out from the bonding portion to the external by adding of the load.
   In order avoid that problem, films of diffusion suppression member for preventing copper from diffusing to aluminum or for substantially preventing the effect of copper diffusion to aluminum were formed on the surfaces of the conductor plate and the heat sink plate in contact with the solder portion. As the result, melting of the core material portion could be prevented and the troubles of forming voids in the bonding portion and incapability of bonding could be solved.
(d) Before bonding the conductor plate to the ceramic plate, a clad member was formed in advance by bonding the conductor plate to the aluminum alloy solder material through rolling. Then, the surface of the conductor plate was plated with nickel, and the clad member was stamped into a desired dimension using a press and then laminated and bonded on the ceramic plate. As the result, the problem of occurrence of displacement was solved, and a high-yield manufacturing method suitable for mass production and capable of reducing number of laminating processes could be attained.
   Further, the clad member may be formed by inserting and roll-bonding a diffusion suppression member for preventing diffusion of a constituent of the conductor plate to aluminum or suppressing the effect of diffusion of the constituent of the conductor plate to aluminum between the conductor plate and the aluminum alloy group solder, which further improves the productivity.
(e) By employing a composite material (Cu/Cu₂O) of copper (Cu) and cuprous oxide (Cu₂O) particles for the heat sink plate, the difference in the thermal expansion coefficient between the heat sink plate and the ceramic plate was decreased. The thermal expansion coefficient of the composite material is gradually decreased as the ratio of cuprous oxide dispersed in copper is increased. For example, when cuprous oxide is dispersed in copper by 50 volume %, the thermal expansion coefficient becomes about 10 ppm/°C. As the result, the thermal stress of the bonding portion between the ceramic plate and the heat sink plate can be reduced. The composite material is used as a sintered material of copper powder and cuprous oxide powder, a melted material of dispersing cuprous oxide particles in a copper base, and hot forged materials and hot rolled materials of the above materials, and cold rolled materials of the hot forged and hot rolled materials. The cuprous particle of melted material is in a complex shape having projections and depressions, but plastic work changes the shape to a particle shape, and particularly rolling work changes the shape to a rod shape stretching in the stretching direction by the work. It is preferable that the diameter of the particle or the rod-shaped particle is smaller than 200 µm. By employing the copper composite material for the heat sink plate as described above, troubles such as occurrence of separation in the bonding portion due to thermal stress produced in the bonding portion could be completely eliminated even if the semiconductor power element heat dissipation board was used under a severe environment having a large number of thermal shocks. In addition, a good result similar to the above could be obtained when an Al-SiC composite material having a small thermal expansion coefficient was employed for the heat sink plate.
   A semiconductor power element is bonded onto the surface of the conductor plate with solder, and the conductor plate itself is also used as a current-carrying path for conducting a large current. Therefore, it is preferable that the conductor plate is made of a low electric resistance material such as copper, a copper alloy, aluminum or an aluminum alloy. Further, although the thickness of the heat sink plate is generally several millimeters, the thickness of the conductor plate is generally several hundreds micrometers.
   Therefore, the ill influence of the thermal stress caused by the difference of thermal expansion coefficient between the heat sink plate and the ceramic plate is smaller in the side of the conductor plate having a thinner thickness than in the side of the heat sink. Further, since the Young modulus of aluminum is smaller than those of copper or a copper alloy, the ill influence of the thermal stress becomes a problem when copper or a copper alloy is used for the conductor plate. Therefore, by using a double layer structure of copper and aluminum or a copper alloy and an aluminum alloy, or aluminum or an aluminum alloy as the major material of the conductor plate, the influence of the thermal stress in the bonding portion between the conductor plate and the ceramic plate could be reduced. In the case where copper or a copper alloy is employed for the conductor plate, it is very effective that the thickness of the aluminum alloy solder portion is made sufficiently thick (at least hundreds µm).
(f) By forming the aluminum alloy group solder into the above-mentioned clad member, flowing-out of the melted solder by adding a load at bonding could be as small as possible to make the thickness of the melted solder portion thin. Even if a very small amount of melted solder flowed out, the very small amount of melted solder could be made to flow back toward the direction of the plane of the aluminum alloy group solder portion by forming the plane dimension of the aluminum alloy group solder portion between the ceramic plate and the heat sink plate so as to project by at least 1 millimeter or more from the end portion of the ceramic plate or so as to depress by at least 1 millimeter or more. As the result, the very small amount of melted solder could be prevented from flowing in the vertical direction, and accordingly electric short circuit between the conductor plate and the heat sink plate could be completely eliminated.
(g) Since the melting point of the known conventional aluminum alloy group solder was as high as about 580 °C (as described in the above-mentioned item (c)), bonding could not be performed under the condition of 400 °C class low temperature in which the melting point was lower than 500 °C. The inventors of the present invention had studied various kinds of aluminum alloy solders described below, and then the bonding under the condition of 400 °C class low temperature was established. That is, by choosing Al-Ge alloys, Al-Ga alloys, Al-Mg alloys, Al-Li alloys, Al-Sn alloys, Al-Zn alloys and Al-Sn-Zn alloys, the relationship between the amount (weight %) of the metal to be added to aluminum of these solders and the melting point was studied and the bonding property to the ceramic was evaluated. The melting points of all the solders added the above-described metals to aluminum can be lowered down to 500 °C as the amount of the added metals is increased, and thereby forming of the Al/Cu intermetallic chemical compound can be substantially decreased. There, the melting point means a temperature at which the alloy melts.
   The melting point of the Al-Ge group solder was decreased to 610 °C in 20 % Ge, 570 °C in 30 % Ge and 510 °C in 40 % Ge in weight percentage, and the eutectic reaction occurred and the melting point became the minimum value of 420 °C in 51 % Ge. The melting point of 420 to 500 °C was obtained within the range of Ge content of 40 to 60 %, which was preferable.
   The melting point of the Al-Ga group solder was decreased to 620 °C in 20 % Ga, 550 °C in 40 % Ga, 510 °C in 50 % Ga, 470 °C in 60 % Ga, 420 °C in 70 % Ga and 340 °C in 80 % Ga in weight percentage. The melting point of 300 to 500 °C was obtained within the range of Ga content of 52 to 85 %, which was preferable.
   The melting point of the Al-Mg group solder was decreased to 550 °C in 20 % Mg, 490 °C in 30 % Mg and 450 °C in 40 % Mg in weight percentage, and the eutectic reaction occurred and the melting point became the minimum value of 437 °C in 66 % Mg. The melting point of 437 to 490 °C was obtained within the range of Mg content of 30 to 70 %, which was preferable.
   The melting point of the Al-Li group solder was decreased to 690 °C in 20 % Li, 580 °C in 40 % Li, 490 °C in 50 % Li, 420 °C in 60 % Li, 330 °C in 70 % Li and 290 °C in 80 % Li in weight percentage. The melting point of 300 to 500 °C was obtained within the range of Li content of 48 to 75 %, which was preferable.
   Similarly, the melting point of the Al-Sn group solder obtained was 350 to 500 °C within the range of Sn content of 93 to 98 %, and the melting point of the Al-Zn group solder obtained was 420 to 500 °C within the range of Zn content of 75 to 95 %,, which were preferable. Further, in regard to the Al-Sn-Zn group solder, an aluminum alloy solder having a melting point lower than 500 °C could be obtained.
   By using the aluminum alloy group solder having a melting point below 500 °C and bonding under the condition of 400 °C class at working temperature lower than 500 °C, the productivity of the heat dispassion board for semiconductor power element and the conductor plate of the heat dispassion board for semiconductor power element could be improved. Further, since the working temperature at bonding was lower than the eutectic temperature (melting temperature) of aluminum and copper of 548 °C, the thickness of produced aluminum chemical composition (Al/Cu) could be decreased as thin as possible even if the film of the diffusion suppression member for preventing copper or a copper alloy from diffusing to aluminum or for substantially suppressing the effect of diffusion to aluminum was not formed on the surfaces of the conductor plate and the heat sink plate in contact with the solder material portion. Furthermore, since the bonding temperature was low, the value of the residual thermal stress produced in the bonding portion became smaller than that in the case where the conventional aluminum alloy solder material having a high melting point of 580 °C. As the result, similarly to the cases of taking the measures of the items (a) to (e), the bonding strength of the bonding portion was increased to improve the reliability.
(h) On the other hand, even in the case where the ceramic plate was directly bonded to the heat sink plate with the aluminum alloy solder without forming the diffusion suppression member in the copper side, it was found that a high bonding strength could be obtained by bonding using a composite solder having the aluminum alloy group solder portion formed on one surface or the aluminum alloy group solder portions formed on the both surfaces of a core material portion made of aluminum or an aluminum alloy.

It is preferable that the above-mentioned conductor plate is made of any one of copper, a copper alloy, a laminated member of copper and aluminum, aluminum, an aluminum alloy, and a laminated member of a copper alloy and an aluminum alloy. It is also preferable that the above-mentioned ceramic plate is made of any one of alumina, aluminum nitride and silicon nitride, and the above-mentioned conductor plate is made of any one of copper, a copper alloy, aluminum, an aluminum alloy, an Al-SiC composite material, and a composite material of copper and cuprous oxide.

It is preferable that the above-mentioned aluminum alloy group solder portion between the ceramic plate and the heat sink plate is projected by at least 1 millimeter or more from the end portion of the ceramic plate or is depressed by at least 1 millimeter or more; and that the conductor plate, the ceramic plate and the heat sink plate are successively laminated, and then these plate are bonded using the aluminum alloy group solder under a vacuum atmosphere or an inert atmosphere; and that the conductor plate, the ceramic plate and the heat sink plate are bonded using the aluminum alloy group solder by heating the laminated body under a vacuum atmosphere or an inert atmosphere while a load is being added to the laminated body.

In a semiconductor power element heat dissipation board which is formed by successively laminating a ceramic plate and a heat sink plate on a conductor plate using an aluminum alloy group solder having a high melting point of about 580 °C, or in a conductor plate of the heat dissipation board, the present invention is characterized by that the aluminum alloy group solder portion is formed by pre-cladding the aluminum alloy group solder on one surface or both surfaces of a core material portion made of aluminum or an aluminum alloy, and a surface of at least any one of the conductor plate and the heat sink plate opposite to the aluminum alloy group solder portion is coated with a diffusion suppression member for suppressing diffusion between the conductor plate or the heat sink plate and aluminum in the solder; or by that the conductor plate is integrated with the diffusion suppression member for suppressing diffusion between the conductor plate and aluminum in the solder to form a one-piece structure; or by that the solder material portion is formed of a clad member which is bonded to the conductor plate through the diffusion suppression member for suppressing diffusion between the conductor plate and aluminum in the solder to form a one-piece structure.

In a semiconductor power element heat dissipation board in which a conductor plate formed by integrating a conductor plate made of copper or a copper alloy with a conductor plate made of aluminum or an aluminum alloy, or with a conductor plate made of aluminum or an aluminum alloy having an aluminum alloy group solder, or with a core member made of aluminum or an aluminum alloy having an aluminum alloy group solder to form a one-piece structure is bonded to a ceramic plate by an aluminum alloy group solder having a melting point as high as about 580 °C, or in a conductor plate of the heat dissipation board, the present invention is characterized by that a diffusion suppression member for suppressing diffusion between the conductor plate made of copper or a copper alloy and aluminum in the solder is provided between the conductor plate made of copper or a copper alloy and the conductor plate made of aluminum or an aluminum alloy or between the conductor plate made of copper or a copper alloy and the core member, or by that nickel is plated on a surface of the conductor plate opposite to a surface of the conductor plate having the aluminum alloy group solder formed thereon, and a diffusion suppression member for suppressing diffusion between the conductor plate and aluminum in the solder is provided between the nickel plating layer and the conductor plate.

In a heat sink plate for a semiconductor power element heat dissipation board in which a ceramic plate is bonded to the heat sink plate made of copper, a copper alloy or a copper composite material by an aluminum alloy group solder having a melting point as high as about 580 °C, the present invention is characterized by that a diffusion suppression member for suppressing diffusion of aluminum in the solder to the heat sink plate is provided on a bonding side surface of the ceramic plate.

In a semiconductor power element heat dissipation board which is formed by successively laminating a ceramic plate and a heat sink plate on a conductor plate using an aluminum alloy group solder, or in a conductor plate of the heat dissipation board, the present invention is characterized by that the aluminum alloy group solder has a melting point lower than 500 °C, and working temperature at bonding is low temperature of 400 °C class; or by that the aluminum alloy group solder has a melting point lower than 500 °C, and working temperature at bonding is low temperature of 400 °C class, and the aluminum alloy group solder portion is pre-cladded on one surface or on the both surfaces of a core material portion made of aluminum or an aluminum alloy.

By combining some of these measures, the productivity of the semiconductor power element heat dissipation board and the conductor plate could be improved, and at the same time, a high bonding strength without voids can be obtained. Accordingly, the troubles such as separation of the bonding portion caused by thermal stress produced in the bonding portion can be eliminated even if the semiconductor power element heat dissipation board is used under a very severe environment having a very large number of thermal shocks.

### BRIEF DESCRIPTION OF THE DRAWINGS

FIG. 1 is a cross-sectional view showing an embodiment of a semiconductor power element heat dissipation board in accordance with the present invention.
FIG. 2 is an exploded cross-sectional view showing the semiconductor power element heat dissipation board of FIG. 1 before bonding.
FIG. 3 is a cross-sectional view showing aluminum alloy group solder portions.
FIG. 4 is a cross-sectional view showing other embodiments of conductor plate portion assemblies.
FIG. 5 is a cross-sectional view showing another embodiment of a semiconductor power element heat dissipation board in accordance with the present invention.
FIG. 6 is an exploded cross-sectional view showing the semiconductor power element heat dissipation board of FIG. 5 before bonding.
FIG. 7 is a cross-sectional view showing embodiments of conductor plate portion assemblies.
FIG. 8 is a cross-sectional view showing another embodiment of a semiconductor power element heat dissipation board in accordance with the present invention.
FIG. 9 is a cross-sectional view showing another embodiment of a semiconductor power element heat dissipation board in accordance with the present invention.
FIG. 10 is a cross-sectional view showing another embodiment of a semiconductor power element heat dissipation board in accordance with the present invention.
FIG. 11 is a cross-sectional view showing another embodiment of a semiconductor power element heat dissipation board in accordance with the present invention.
FIG. 12 is an exploded cross-sectional view showing another embodiment of a semiconductor power element heat dissipation board in accordance with the present invention.
FIG. 13 is a cross-sectional view showing another embodiment of a semiconductor power element heat dissipation board in accordance with the present invention.
FIG. 14 is an exploded cross-sectional view showing the semiconductor power element heat dissipation board of FIG. 13 before bonding.
FIG. 15 is a cross-sectional view of a semiconductor power element heat dissipation board which explains a short circuit trouble.
FIG. 16 is a plan view explaining a semiconductor power element heat dissipation board in which countermeasures against short circuit are taken.
FIG. 17 is a cross-sectional view showing another embodiment of a semiconductor power element heat dissipation board in accordance with the present invention.
FIG. 18 is an exploded cross-sectional view showing the semiconductor power element heat dissipation board of FIG. 17 before bonding.

### DESCRIPTION OF THE PREFERRED EMBODIMENTS

Initially, description will be made in Embodiments 1 to 10 on the present invention relating to aluminum alloy group solders of which the melting point is about 580 °C and the working temperature at bonding is 500 °C or higher.

### (Embodiment 1)

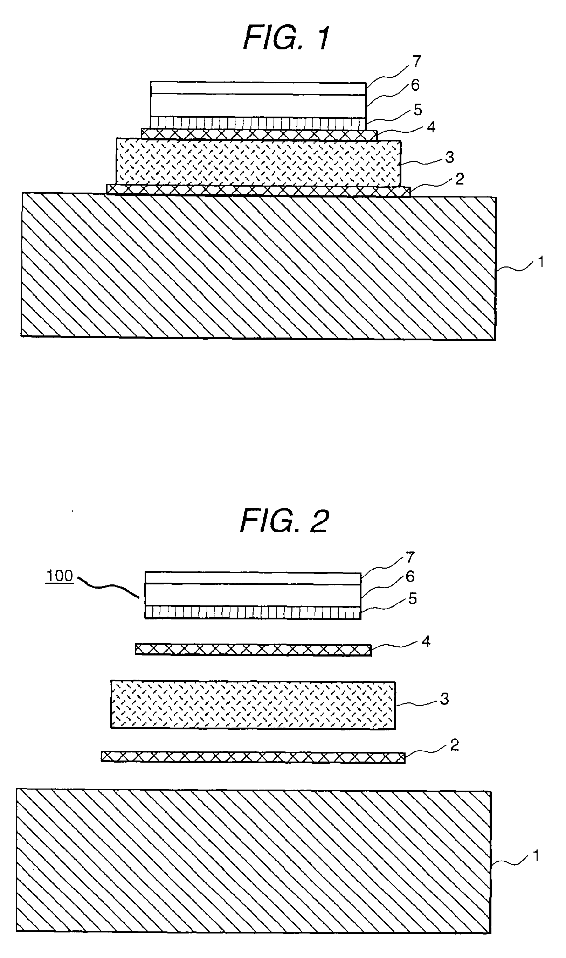

FIG. 1 is a cross-sectional view showing an embodiment of a semiconductor power element heat dissipation board in accordance with the present invention. As shown in the figure, the semiconductor power element heat dissipation board has the structure that a conductor plate 6, a ceramic plate 3 and a heat sink plate 1 are laminated, and then these plates are bonded together using aluminum alloy group solder portions 2 and 4. The conductor plate 6 has a nickel plated film 7 (the thickness is several to 10 µm) on a surface opposite to a surface in contact with the ceramic plate 3, and also has a diffusion suppression member 5 for preventing a component of the conductor plate 6 from diffusing to aluminum in the aluminum alloy group solder 4 or for suppressing the effect of diffusion to aluminum on the surface in contact with the ceramic plate 3.

The diffusion suppression member 5 is made of at least one kind of material selected from the group consisting of pure Ni, pure Cr, pure Ti, pure W, an Ni alloy, a Cr alloy, a Ti alloy and a W alloy, and the thickness is at least 5 µm or thicker in the case of pure nickel, and around several µm in the cases of the other materials. Materials generally used for the heat sink plate 1 are copper, a copper alloy, aluminum and an aluminum alloy. In the case of using aluminum or an aluminum alloy, the aluminum in the heat sink plate only diffuses mutually with the aluminum in the aluminum alloy group solder 2. Therefore, the diffusion suppression member for preventing diffusing to aluminum or suppressing the effect of diffusion to aluminum is not necessary. Further, in the case of using a copper composite material (Cu/Cu₂O) in which cuprous oxide (Cu₂O) is dispersed in copper (Cu), even if the heat sink plate 1 is made of a copper group composite material, part of the surface of the heat sink plate 1 has been changed to cuprous oxide which is difficult to react with aluminum. Therefore, even when the film of the diffusion suppression member for preventing diffusion to aluminum was not formed on the surface of the heat sink plate 1 in contact with the aluminum alloy group solder 2, the producing amount of Al/Cu chemical compound could be suppressed to a certain degree. Further, in the case of using a non-copper group material of Al-SiC composite material for the heat sink plate 1, the film forming of the diffusion suppression member for preventing diffusion to aluminum was unnecessary. Therein, the figure shows a case where the conductor plate 6 is made of copper or a copper alloy.

The solder portions of the aluminum alloy group solder portions 2 and 4 are made of an Al-Si alloy, an Al-Si-Mg alloy, am Al-Ge alloy or an Al-Si-Ge alloy. In the case of using Al-12%Si alloy or Al-12%Si-Ge alloy for the solder portions, the eutectic temperature (melting temperature) is about 580 °C. After laminating the conductor plate 6, the ceramic plate 3 and the heat sink plate 1 as shown in the figure, a load adding jig (not shown in the figure) made of ceramic such as alumina, not react with nickel, was brought in contact with the nickel plated film 7 formed on the surface of the conductor plate 6, and then these laminated plates were heated up to 580 °C to 610 °C under a vacuum atmosphere or an inert atmosphere and under a bonding condition of adding a load of 0.1 to 10 MPa per unit area. As described above, a high reliable semiconductor power element heat dissipation board could be obtained.

FIG. 2 is an exploded cross-sectional view showing the semiconductor power element heat dissipation board of FIG. 1 before bonding. On the premise that All elements having the same reference characters to be described below have the same functions as described above, the description hereinafter will be made. The conductor plate 6 having the nickel plated film 7 formed on one surface and a film of the diffusion suppression member formed on the other surface is indicated by a conductor plate portion assembly 100. After laminating the aluminum alloy group solder 2, the ceramic plate 3, the aluminum alloy group solder 4, the conductor plate portion assembly 100 on the heat sink plate 1 in this order, the plates are bonded under the above-mentioned condition. As described above, the manufacturing method is good in the productivity because the aluminum alloy group solder portions 2 and 4 are films but not printed parts.

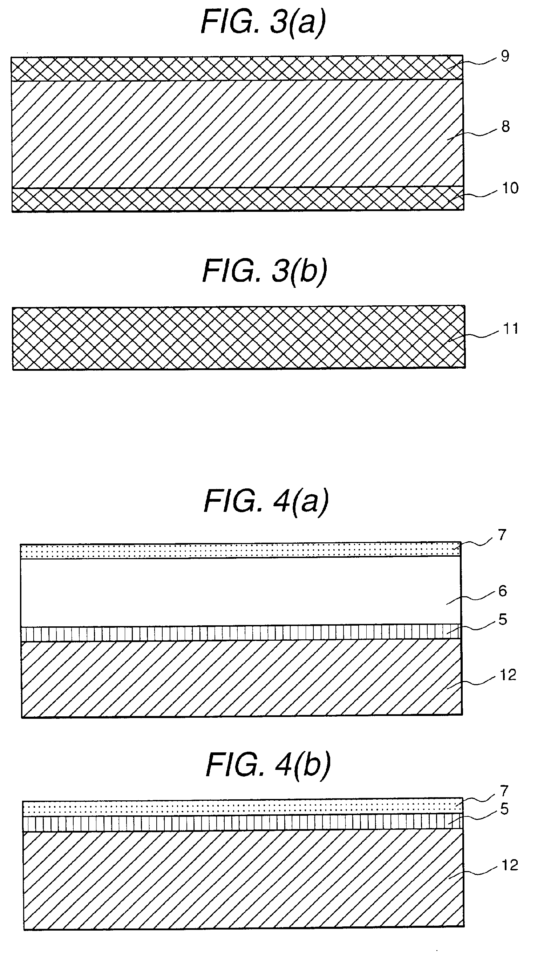

FIG. 3 is detailed cross-sectional views showing the aluminum alloy group solder portions 2 and 4. FIG. 3 (a) is a cross-sectional view showing a composite solder portion which is formed by pre-cladding thin films of aluminum alloy group solder portions 9 and 10 on the both surfaces of a core portion 8 made of aluminum or an aluminum alloy through rolling. The clad member composed of laminated pieces of the solder portion 9/- the core material portion 8/ the solder portion 10 is a film having a total thickness of hundred to hundreds micrometers, and the thickness of the solder portions 9 and 10 is about 10 % as thin as the thickness of the core material portion 8. The solder portions 9, 10 are made of an Al-Si alloy, Al-Si-Mg alloy, an Al-Ge alloy or an Al-Si-Ge alloy. For example, in the case of using Al-12%Si alloy or Al-12%Si-Ge alloy for the solder portions, the eutectic temperature (melting temperature) of the solder portions is about 580 °C which is lower than the aluminum melting temperature of 660 °C of the core material portion. The core material portion may have the aluminum alloy group solder portion 9 or 10. The core material portion 8 made of an aluminum alloy is in the solid phase under the melting temperature of the aluminum alloy group solder portions 9 and 10, and is in the solid phase at the bonding temperature, and has the melting temperature higher than the bonding temperature. Further, when the same element is added to these aluminum alloys, the content in the aluminum alloy of the core material portion 8 is smaller than the content in the aluminum alloy of the aluminum alloy group solder portions 9, 10. When the other element is added, the content is adjusted depending the purpose.

Therefore, even when the laminated body is heated up to a high temperature of 580 °C to 610 °C under a vacuum atmosphere or an inert atmosphere after forming the laminated body by laminating the conductor plate 6, the ceramic plate 3 and the heat sink plate 1, only the solder portions are melted but the core material portion is not melted. As the result, the solder portions 9 and 10 could be prevented from flowing out from the bonding portions to the external because the thickness of the solder portions 9 and 10 was about 10 % as thin as the thickness of the core material portion 8 even under the bonding condition of adding a load of 0.1 to 10 MPa per unit area. As described above, since the clad member composed of laminated pieces of the solder portion/ the core material portion/ the solder portion had a very small amount of voids produced in the bonding portion and had no troubles such as incapability of bonding, the clad member was very effective as an aluminum alloy group solder member for materializing a high reliable semiconductor power element heat dissipation board capable of obtaining a bonding strength higher than several tens MPa.

FIG. 3 (b) shows an aluminum alloy group solder portion 2 or 4 without any core material portion. As shown in the figure, The solder portion 11 is totally made of a solder material which melts at a temperature under the bonding condition. In this case, the bonding strength could be secured without the core material portion when the thickness of the solder portion 11 was thinner than several tens micrometer though a small amount of voids were produced. However, the bonding load per unit area was required to be decreased as low as possible.

### (Embodiment 2)

FIG. 4 is a cross-sectional view showing other embodiments of conductor plate portion assemblies 100 of the conductor plate 6. The conductor plate portion assembly 100 of FIG. 4 (a) is constructed by forming a nickel plated film 7 on one surface of the conductor plate 6 made of copper or a copper alloy, and by forming a film of the diffusion suppression member 5 for preventing copper from diffusing to the aluminum conductor plate 12 or for suppressing the effect of the copper diffusion to the aluminum conductor plate 12 on the other surface through plating or sputtering. The conductor plate portion assembly 100 in this figure can be obtained by forming the film of the diffusion suppression member 5 on the conductor plate 6, and then by forming a nickel film 7 through plating on a clad member having the aluminum conductor plate 12 firmly bonded to the conductor plate through rolling. Otherwise, the conductor plate portion assembly 100 in this figure can be obtained by bonding the tree layer materials of a film to be formed in the conductor plate 6, the diffusion suppression member 5 and the aluminum conductor plate 12 through rolling at a time, and then by forming the nickel film 7 through plating. Therein, the thickness of the conductor plate 6 made of copper or a copper alloy and the thickness of the aluminum conductor plate 12 are nearly equal to each other and 150 to 250 µm, respectively.

The conductor plate portion assembly 100 of FIG. 4 (b) is constructed by forming a film of the diffusion suppression member 5 on the surface of the aluminum conductor plate having a thickness of 300 to 500 µm, and then forming the nickel film 7 on the surface of the diffusion suppression member 5 through plating. The role of the diffusion suppression member 5 in this figure is to prevent diffusion of nickel in the nickel film 7 to the aluminum conductor 12 or to suppress the effect of the diffusion to the aluminum conductor 12. Therein, when the thickness of the nickel film 7 was thicker than 10 µm, it was experimentally found that the diffusion suppression member 5 might be eliminated. The aluminum conductor plate 12 on FIG. 4 (b) may be formed of an aluminum alloy as well as pure aluminum.

As described above, by employing the double layer structure of copper/- aluminum or an copper alloy/ aluminum alloy or aluminum or an aluminum alloy as the major material for forming the conductor plate, the ill influence of the thermal stress due to the thermal expansion difference between the conductor plate portion assembly 100 and the ceramic plate 3 to the bonding portion between them could be reduced compared to the case where the conductor plate 6 of FIG. 1 was formed of the major material of copper or a copper alloy. As the result, similarly to the above, the high reliability could be secured even if the semiconductor power element heat dissipation board was used under a severe environment having a large number of thermal shocks.

### (Embodiment 3)

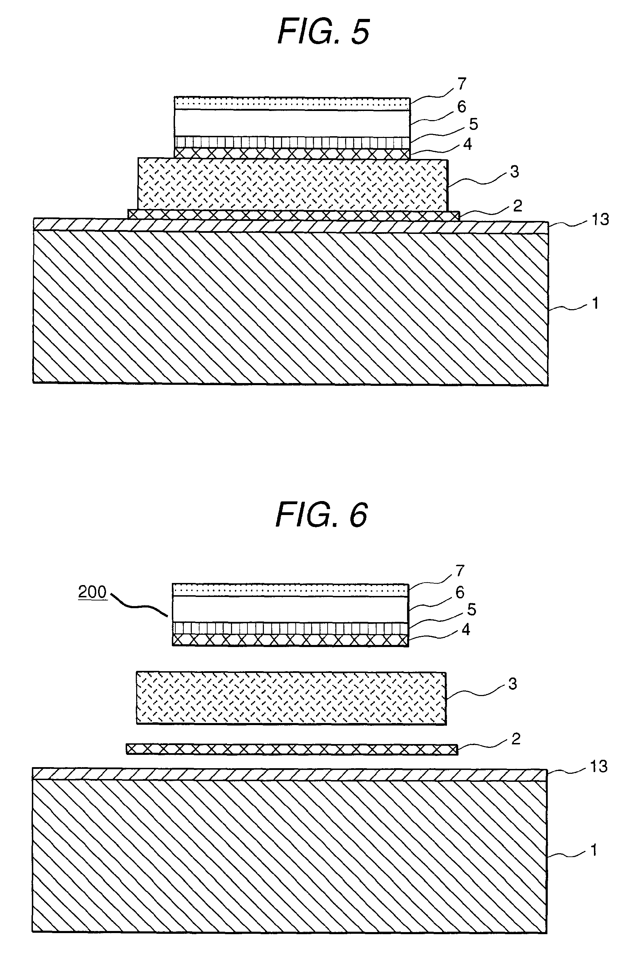

FIG. 5 is a cross-sectional view showing another embodiment of a semiconductor power element heat dissipation board in accordance with the present invention. The semiconductor power element heat dissipation board in this figure is different from the heat dissipation board shown in FIG. 1 in the following two points.

The first different points are that copper, a copper alloy or a copper composite material is used as the material for the heat sink plate 1, and a film of the diffusion suppression member 13 for preventing copper from diffusing to aluminum in the aluminum alloy group solder 2 or for suppressing the effect of diffusion to aluminum is formed on the surface of the ceramic plate 3. The diffusion suppression member 13 is made of at least one kind of material selected from the group consisting of pure Ni, pure Cr, pure Ti, pure W, an Ni alloy, a Cr alloy, a Ti alloy and a W alloy, and the thickness is at least 5 µm or thicker in the case of pure nickel, and around several micrometers in the cases of the other materials. By doing so, it was possible to completely prevent producing of Al/Cu chemical compound which was produced by reaction of copper in the heat sink plate 1 with the aluminum alloy group solder 2. As the result, the bonding strength of the bonding portion was improved. Particularly, in the case of applying a copper composite material (Cu/Cu₂O) in which cuprous oxide (Cu₂O) is dispersed in copper (Cu) to the heat sink plate 1, the thermal stress in the bonding portion between the ceramic plate 3 and the heat sink plate 1 can be substantially reduced. As the result, the troubles such as separation of the bonding portion due to the thermal stress produced in the bonding portion could be completely eliminated even if the semiconductor power element heat dissipation board was used under a severe environment having a large number of thermal shocks.

The second different points are that before bonding the conductor plate 6 to the ceramic plate 3, a clad member formed in advance by inserting the diffusion suppression member 5 between the conductor plate 6 and the aluminum alloy group solder 4 and then bonding these plates through rolling. After that, a nickel plated film 7 is formed on one surface of the conductor plate 6, and then the clad member is formed in a desired dimension through punching work using a press and laminated on the ceramic plate 3 to be bonded.

FIG. 6 is an exploded cross-sectional view showing the semiconductor power element heat dissipation board of FIG. 5 before bonding. The laminated body of the nickel film 7, the conductor plate 6, the diffusion suppression member 5 and the aluminum alloy group solder 4 is indicated by a conductor plate portion assembly 200. As described above, the conductor plate portion assembly 200 is formed in a desired dimension through punching work using the press after forming the nickel plated film 7 on one surface of the clad member. As the result, the problem of displacement at laminating can be completely eliminated, and number of the laminating processes can be decreased compared to the case of FIG. 1. Accordingly, it is possible to realize the manufacturing method capable of securing a high bonding strength, suitable for the mass production and having a high yield.

The heat sink plate 1 is made of copper or a copper alloy, and integrated with the diffusion suppression member 5 attached in the bonding side by the aluminum alloy group solder 4 in a one-piece structure. The aluminum alloy group solder member 4 can employ those shown in FIG. 3 (a) and (b), similarly to Embodiment 1.

### (Embodiment 4)

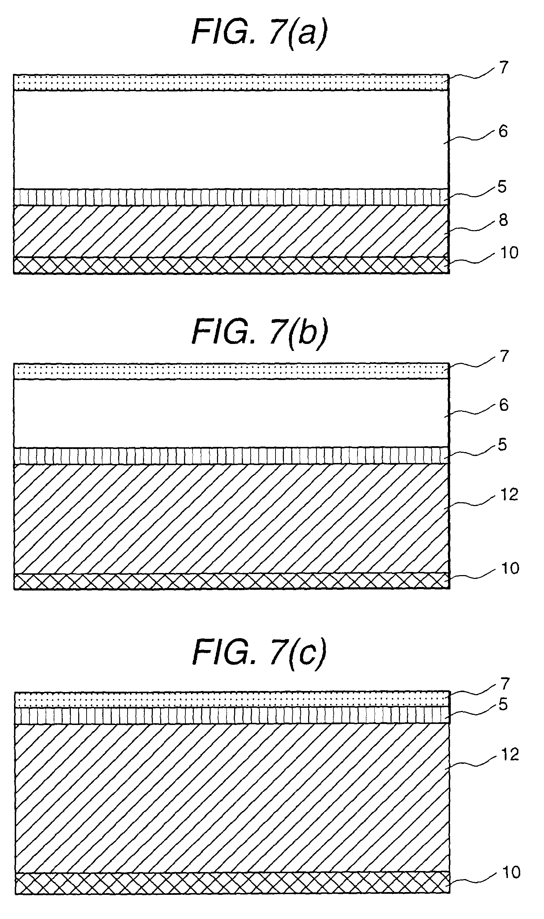

FIG. 7 is a cross-sectional view showing other embodiments of the conductor plate portion assemblies 200. The conductor plate portion assembly 200 in FIG. 7 (a) is a clad member formed by inserting the diffusion suppression member 5 between the conductor plate 6 made of copper or a copper alloy and the aluminum alloy group solder member having a solder portion 10 formed on one surface of the core material portion 8 made of aluminum or an aluminum alloy, and firmly bonding the conductor plate 6, the diffusion suppression member 5 and the solder member, and then forming the nickel plated film 7 on the surface of the conductor plate 6. The conductor plate portion assembly shown in the figure can be obtained by forming the clad member into a desired dimension by punching work using a press. Therein, the diffusion suppression member 5 is formed of the same material as the above-mentioned material preventing diffusion of copper to aluminum of the core material portion 8 or suppressing the effect of diffusion to the aluminum, and the thickness is at least 5 µm or thicker in the case of pure nickel, and above several µm in the cases of the other materials. The thickness of the conductor plate 6 is several hundreds µm which is several times as thick as the thickness of the core material portion 8.

The conductor plate portion assembly 200 in FIG. 7 (b) is different from that shown in FIG. 7 (a) in the following point. That is, the clad member is formed by replacing the core material portion 8 by the aluminum conductor plate 12 made of aluminum or an aluminum alloy, and the nickel plated film 7, the conductor plate 6 made of copper or a copper alloy, the diffusion suppression member 5, the aluminum conductor plate 12 made of aluminum or an aluminum alloy and the aluminum alloy group solder 10 are successively laminated. The thickness of the conductor plate 6 made of copper or a copper alloy and the thickness of the aluminum conductor plate 12 in the figure are nearly equal to each other and nearly 150 to 250 µm, respectively.

The conductor plate portion assembly 200 in FIG. 7 (c) is different from that shown in FIG. 7 (b) in the following point. That is, the clad member is formed by removing the conductor plate 6 from the clad member of FIG. 7 (b), and the nickel plated film 7, the diffusion suppression member 5, the aluminum conductor plate 12 made of aluminum or an aluminum alloy and the aluminum alloy group solder 10 are successively laminated. The thickness of the aluminum conductor plate 12 in the figure is nearly equal to each other and nearly 300 to 500 µm. The main current flow paths of FIG. 7 (a), FIG. 7 (b) and FIG. 7 (c) are the conductor plate 6, the conductor plate 6/ the aluminum conductor plate 12, and the aluminum plate 12, respectively. In this embodiment, a high bonding strength can be also obtained.

### (Embodiment 5)

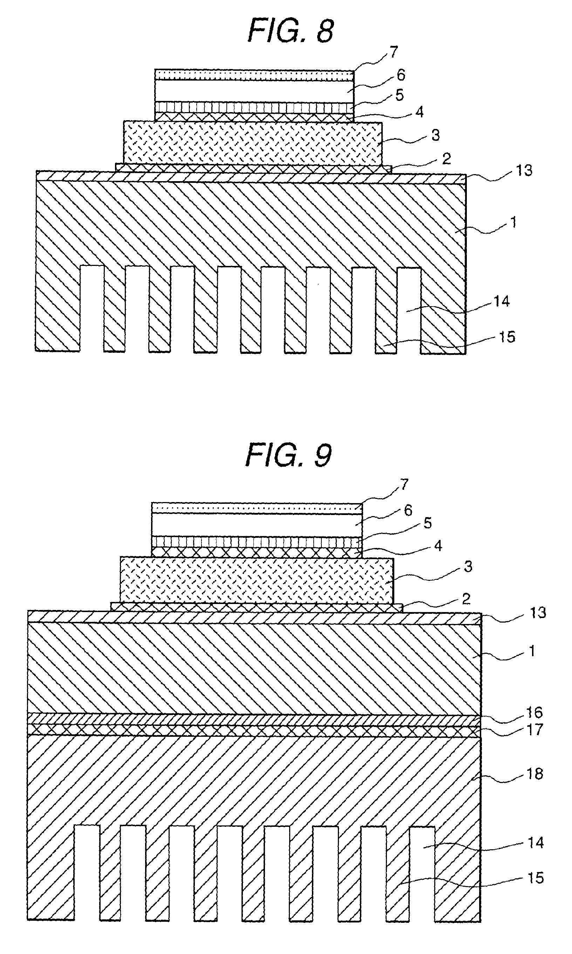

FIG. 8 is a cross-sectional view showing another embodiment of a semiconductor power element heat dissipation board in accordance with the present invention. The semiconductor power element heat dissipation board in this figure is different from the heat dissipation board shown in FIG. 5 in the following point. That is, the board is that grooves 14 are formed in the heat sink plate 1 made of copper or a copper alloy to form many fins 15 on the surface. By doing so, the present invention can be applied to the semiconductor power element heat dissipation board which has a further increased heat dissipation efficiency by providing the fins and a high bonding strength similarly to the aforementioned board. Further, in the present embodiment, the aluminum alloy group solder members 2 and 4 can employ that shown in FIG. 3 (a), similarly to Embodiment 1.

### (Embodiment 6)

FIG. 9 is a cross-sectional view showing another embodiment of a semiconductor power element heat dissipation board in accordance with the present invention. The semiconductor power element heat dissipation board in this figure is different from the heat dissipation board shown in FIG. 5 in the following point. That is, the different point is that a second heat sink plate 18 having fins 15 by forming grooves 14is bonded to a first heat sink plate 1 by the solder 17. There, the heat sink plate 1 is formed of a copper composite material member made of a copper group material. The diffusion suppression member 16 formed on the surface of the heat sink plate 1 is formed of the same material as the above-mentioned material preventing diffusion of copper in the heat sink plate 1 to the aluminum alloy group solder 17 or suppressing the effect of diffusion to the aluminum, and the thickness is at least 5 µm or thicker in the case of pure nickel, and above several µm in the cases of the other materials. The heat sink plate 1 is made of a copper composite material (Cu/Cu₂O) in which cuprous oxide (Cu₂O) is dispersed in copper (Cu), and the thermal expansion coefficient is about 10 ppm/°C when the content of cuprous oxide is 50 volume %. Therefore, even if the second heat sink plate 18 made of aluminum or an aluminum alloy having a large thermal expansion coefficient is used, the thermal stress in each of the bonding portions becomes small because the heat sink plate 1 made of the copper composite material has the thermal expansion coefficient of which the magnitude is between those of the ceramic plate 3 and the second heat sink plate 18. As the result, the troubles such as separation of the bonding portion due to the thermal stress produced in the bonding portion can be solved even if the semiconductor power element heat dissipation board is used under a severe environment having a large number of thermal shocks, and a high bonding strength can be obtained similarly to the cases described above. Further, the aluminum alloy group solder members 2, 4 and 17 can employ that shown in FIG. 3 (a), similarly to Embodiment 1.

### (Embodiment 7)

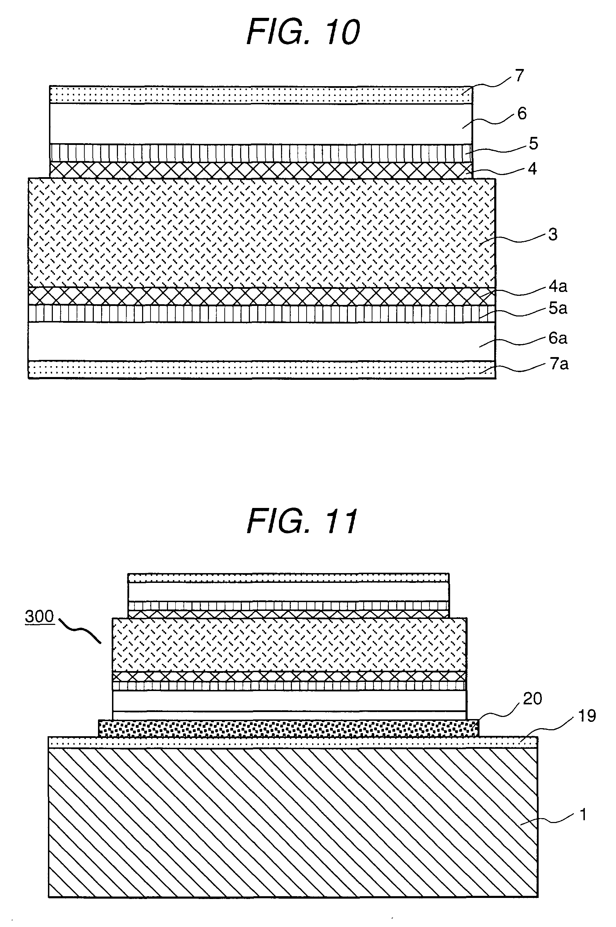

FIG. 10 is a cross-sectional view showing another embodiment of a semiconductor power element heat dissipation board in accordance with the present invention. The board is formed by bonding the conductor plate 6 having the nickel plated film 7 formed on one surface and the diffusion suppression member 5 on the other surface and the heat sink plate 6a having the nickel plated film 7a formed on one surface and the diffusion suppression member 5a on the other surface onto both surfaces of the ceramic plate 1 using the aluminum alloy group solder members 4 and 4a, respectively. There, the conductor plate 6 and the heat sink plate 6a are formed of copper or a copper alloy, and the diffusion suppression member 5 and the diffusion suppression member 5a are formed of the same material as the above-mentioned material preventing diffusion of copper in the conductor plate 6 and in the heat sink plate 6a to aluminum in the aluminum alloy group solder members 4 and 4a or suppressing the effect of diffusion to the aluminum. The thickness of each of the diffusion suppression members is at least 5 µm or thicker in the case of pure nickel, and above several µm in the cases of the other materials. The thickness of the conductor plate 6 and the thickness of the heat sink plate 6a are nearly equal to each other and about several hundreds µm, respectively. In this embodiment, a high bonding strength can be also obtained, similarly to the cases described above. Further, the aluminum alloy group solder members 4 and 4a can employ that shown in FIG. 3 (a), similarly to Embodiment 1.

### (Embodiment 8)

FIG. 11 is a cross-sectional view showing another embodiment of a semiconductor power element heat dissipation board in accordance with the present invention. When the heat dissipation board shown in the previous figure is defined as a heat dissipation board portion assembly 300, the semiconductor power element heat dissipation board is formed by bonding the heat dissipation board portion assembly 300 onto the heat sink plate 1 having the nickel plated film 19 using the solder 20. The conductor plate 6 and the heat sink plate 6a in this figure are bonded by the aluminum alloy group solder members (the bonding temperature is as low as 580 to 610 °C), and accordingly, the thermal stress in the bonding portions is small compared to that of the conventional direct bonding method (the bonding temperature is above 1000 °C) of oxidizing the copper surface utilizing the eutectic of copper suboxide and copper or the conventional active metal solder method (the bonding temperature is about 850 °C). As the result, although the heat dissipation board portion assembly 300 was bonded onto the heat sink plate 1 by the solder 20, the board showed a reliability higher than the reliability of the products of the prior art.

### (Embodiment 9)

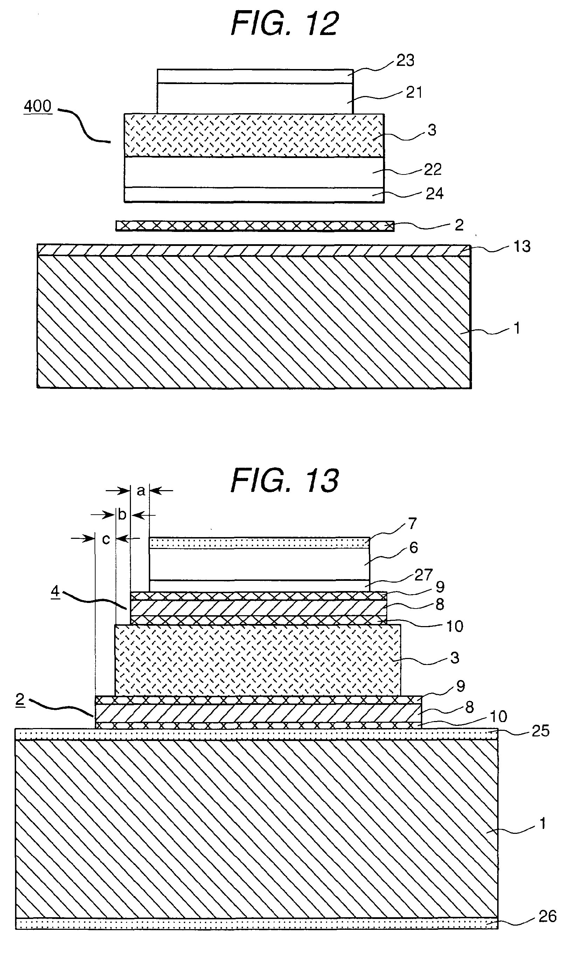

FIG. 12 is an exploded cross-sectional view showing another embodiment of a semiconductor power element heat dissipation board in accordance with the present invention.

A heat dissipation board portion assembly 400 is defined by an assembly which is formed by bonding the conductor plate 21 and the heat sink plate 22 each made of copper or an copper alloy on the both surfaces of the ceramic substrate 3 by the direct bonding method or the active metal solder method of the prior art, and then forming the nickel plated films 23, 24 on the surfaces of the conductor plate 21 and the heat sink plate 22, respectively. The semiconductor power element heat dissipation board is formed by bonding the heat dissipation board portion assembly 400 onto the heat sink plate 1 having a film of the diffusion suppression member 13 using the aluminum alloy group solder 2. The thickness of the conductor plate 21 and the thickness of the heat sink plate 22 are several hundreds µm, respectively. In this embodiment, a high bonding strength can be also obtained by the bonding using the aluminum alloy group solder, similarly to the cases described above. Further, the aluminum alloy group solder member 2 can employ that shown in FIG. 3 (a), similarly to Embodiment 1.

### (Embodiment 10)

FIG. 13 is a cross-sectional view showing another embodiment of a semiconductor power element heat dissipation board in accordance with the present invention. The semiconductor power element heat dissipation board is a board which is formed by bonding the conductor plate 6 having the nickel plated film 7 formed on one surface and the nickel plated film 27 on the other surface and the heat sink plate 1 having the nickel plated film 25 formed on one surface and the nickel plated film 26 on the other surface onto both surfaces of the ceramic plate 3 using the composite solder members having the aluminum alloy group solder portions 9 and 10 formed on the both surfaces of the core material portion 8 made of aluminum or an aluminum alloy. There, in this embodiment, the aluminum alloy group solder portion (corresponds to the part indicated by the reference character 4 or 2 in FIG. 1) is the clad member formed of the laminated pieces of the solder portion 9/ the core material portion 8/ the solder portion 10, and the conductor plate 6 is made of a copper group material of copper or an copper alloy, and the heat sink plate 1 is made of a copper composite material.

When the thickness of the nickel plated films 27 and 25 was thicker than 10 µm and the time exposing high temperature at bonding was not a long period, these nickel plated films sufficiently functioned as the material for preventing copper in the conductor plate 6 and the heat sink plate 1 from diffusing into aluminum in the aluminum alloy group solder members 9 and 10 or for suppressing the effect of diffusion to the aluminum. The laminated body of the conductor plate 6, the ceramic plate 3 and the heat sink plate 1 was heated up to 610 °C and added with a load of 1 MPa through a pressing jig made of ceramic under a vacuum atmosphere or an inert atmosphere. The temperature was kept at610 °C for 10 minutes while the load was being added to the laminated body, and then the temperature was lowered, and the load was released at the time when the temperature of the laminated body became 300 °C. A 1000-cycle thermal shock endurance test of 40 to 150 °C was conducted using a semiconductor power element heat dissipation board manufactured under the above-mentioned bonding condition using the aluminum alloy group solder member having the total thickness (the total thickness of the solder portion 9/ the core material portion 8/ the solder portion 10) of 160 µm. As the result of the test, any trouble such as separation of the bonding portion did not occur.

Test pieces were formed by bonding a copper plate or an aluminum plate to a ceramic (alumina, aluminum nitride or silicon nitride) plate using Al-12%Si alloy solder and adding a load of 1 MPa through the method described in this embodiment. As the result of test using the test pieces, bonding strengths above several tens MPa were obtained, and void (unbonded portion) in the bonding portions was nearly 0 %.

The heat sink plate 1 made of the copper composite material of composite material (Cu/Cu₂O) of copper (Cu) and cuprous oxide (Cu₂O) has a property that cuprous oxide (Cu₂O) in the material is likely reduced to copper (Cu) under a reducing atmosphere. From this viewpoint, the aluminum alloy group solders capable of bonding under a vacuum atmosphere or an inert atmosphere are bonding materials suitable for the copper composite material.

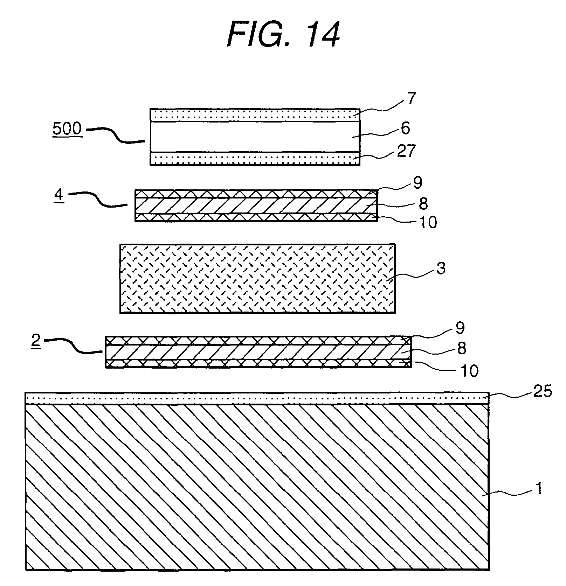

FIG. 14 is an exploded cross-sectional view showing the semiconductor power element heat dissipation board of FIG. 13 before bonding. In the figure, the conductor plate 6 having the nickel plated film 7 formed on one surface and the nickel plated film 27 formed on the other surface is indicated by the conductor plate portion assembly 500, the aluminum alloy group solder members made of the laminated clad members of the solder portion 9/ the core material portion 8/ the solder portion 10 is indicated by the reference characters 4 and 2.

Description will be made below on the trouble of electric short circuit between the conductor plate and the heat sink plate occurring at manufacturing the semiconductor power element heat dissipation board and the preventive method in accordance with the present invention. The dimensional relationship of plane sizes, for example, among the conductor plate 6, the aluminum alloy group solder member 4, the ceramic plate 3 and the aluminum alloy group solder member 2, that is, the offset dimension between the component members indicated by the reference character a, b or c in FIG. 13 was important.

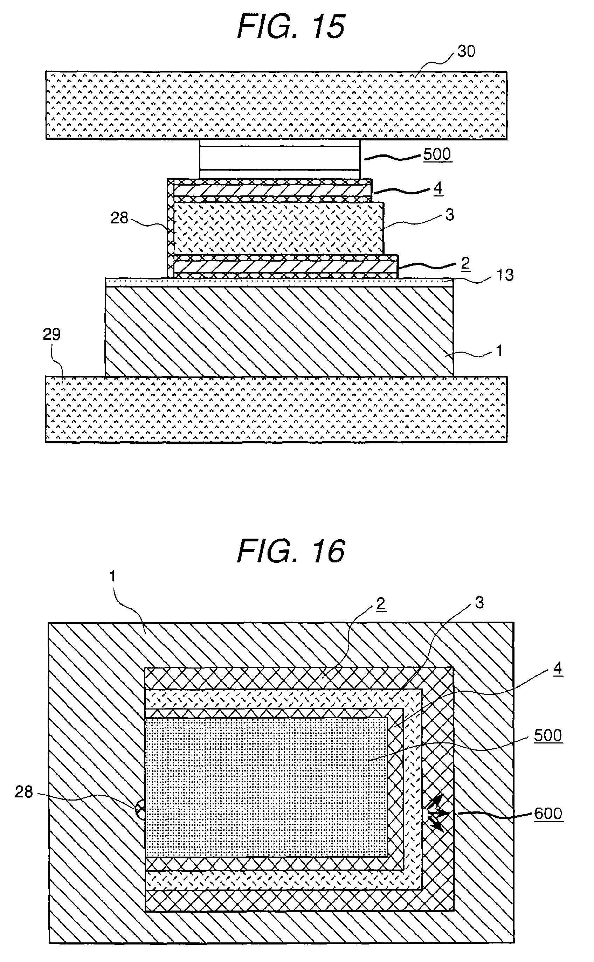

The trouble of electric short circuit between the conductor plate and the heat sink plate and the preventive method will be described below, referring to FIG. 15 and FIG. 16. When the semiconductor power element heat dissipation board, for example, shown in FIG. 13 is manufactured, the conductor plate portion assembly 500, the aluminum alloy group solder member 4, the ceramic plate 3, the aluminum alloy group solder member 2 and the heat sink plate 1 are laminated, and the laminated body is put between a jig 30 and a jig 29, as shown in FIG. 15, and then a load of 0.1 to 10 MPa is added to the laminated body under a high temperature of 580 to 610 °C. The amount of melted solder flowing out from the bonding portion is very small when the aluminum alloy group solder is formed in the clad member. However, when the flatness of the conductor plate portion assembly 500 or the heat sink plate 1 is not so good or when an extraneous object exists in the laminating portion of the laminated body, there occurs a rare case that melted solder locally flows out to form a bridge 28 of the solder material shown in FIG. 15 between the conductor plate portion assembly 500 and the heat sink plate 1. In that case, a trouble of electric short circuit occurs between the conductor plate portion assembly 500 and the heat sink plate 1.

FIG. 16 is a plan view showing a semiconductor power element heat dissipation board. In a case where the conductor plate portion assembly 500, the aluminum alloy group solder member 4, the ceramic plate 3 and the aluminum alloy group solder 2 are laminated as shown in FIG. 16, when the positions of the end portions of the laminated components described above are completely aligned (that is, when the relationship among the dimensions a, b, c shown in FIG. 13 becomes a = b = C = 0), the trouble described above occurs. In FIG. 16, the plane shape of the bridge of solder is indicated by the reference character 28. If the aluminum alloy group solder members 4 and 2 are projected or depressed from the ceramic plate 3 by 1 mm or more so that flow of the melted solder may be received to the gravitational direction, the short circuit trouble does not occur. If the melted solder locally flows out from a position between the ceramic plate 3 and the heat sink plate 1, the flowing-out melted solder flows along the surface of the aluminum alloy solder member 2. Therefore, the flowing-out melted solder does not form the vertical bridge which causes a short circuit between the conductor plate portion assembly 500 and the heat sink plate 1. In FIG. 16, a feature of the melted solder flow along the surface direction is schematically illustrated by arrows 600. In this embodiment, a high bonding strength can be also obtained by using the aluminum alloy group solder members, similarly to the above-described embodiments.

### (Embodiment 11)

The present inventions described in FIG. 1 to FIG. 16 are the embodiments in the cases where the melting temperature of the aluminum alloy group solder material is about 580 °C, and the work temperature at bonding is as high as at least 500 °C or higher. Description will be made below on the present invention in the case where the melting temperature of the aluminum alloy group solder material is 400 °C, and the work temperature at bonding is as low as at least 500 °C or lower.

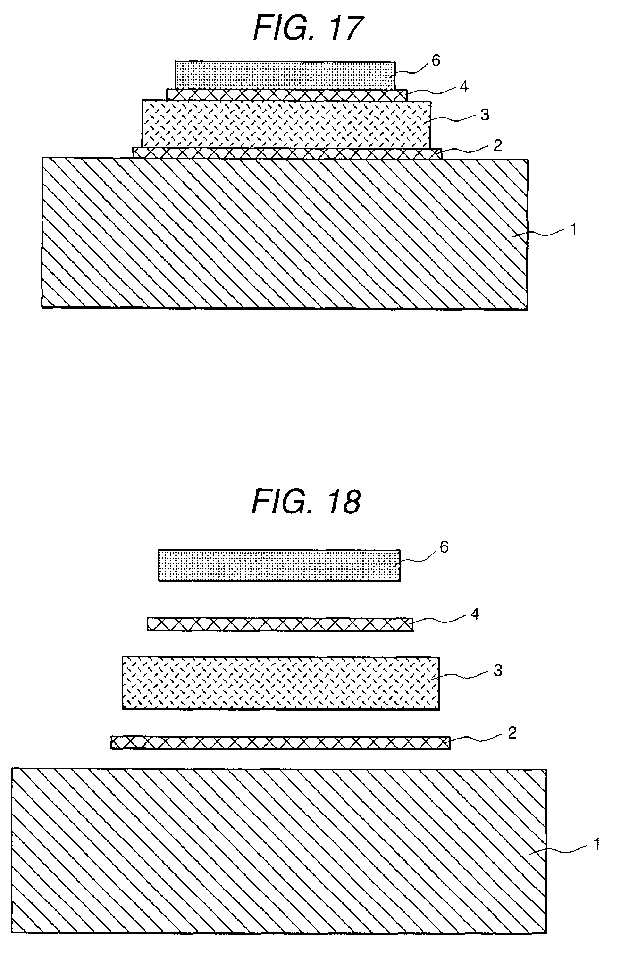

Al-51%Ge (melting point: 420 °C), Al-60%Ga (melting point: 470 °C), Al-40%Mg (melting point: 450 °C), Al-60%Li (melting point: 420 °C) and Al-Sn-Zn group were selected as the aluminum alloy group solders, and semiconductor power element heat dissipation boards were manufactured using the selected aluminum alloy group solders. FIG. 17 shows an embodiment of a semiconductor power element heat dissipation board in accordance with the present invention which uses the low temperature aluminum alloy group solder materials described above.

As shown in the figure, the semiconductor power element heat dissipation board is formed by laminating the conductor plate 6 made of copper or a copper alloy, the ceramic plate 3 and the heat sink plate 1 made of copper or a copper alloy, and then bonding these plates using the aluminum alloy group solder material member 4 and 2. Even if a copper group material such as copper or a copper alloy or a copper composite material was employed for the conductor plate 6 and the heat sink plate 1 though there was no need to say the case of employing aluminum or an aluminum alloy, it was unnecessary to form the film of the diffusion suppression member for preventing diffusion of copper to aluminum in the aluminum alloy group solder or for suppressing the effect of diffusion to the aluminum.

This reason is that because the work temperature at bonding is lower than the eutectic temperature (melting temperature) of aluminum and copper of 548 °C, the thickness of produced aluminum chemical compound (Al/Cu) can be made very thin even if the film of the diffusion suppression member is not formed. Further, since the work temperature at bonding is low temperature of 400 °C class, the productivity is improved and the residual thermal stress produced in the bonding portion is decreased to a very small value. Furthermore, by employing the laminated clad member of the solder portion/- the core material portion/ the solder portion to the aluminum alloy group solder material, a highly reliable semiconductor power element heat dissipation board without void in the bonding portion and having a high bonding strength could be obtained. In addition, the bonding strength and the state of void formation in this embodiment were similar to those in the above-mentioned embodiments.

FIG. 18 is an exploded cross-sectional view showing the semiconductor power element heat dissipation board of FIG. 17 before bonding.

A heat dissipation board having a very simple structure can be obtained.

It is no need to say that the heat dissipation board capable of solving at least one of the items (a) to (g) in the aforementioned problems of the prior art is included in the present invention.

Further, as described above, by using the composite solder material member formed by cladding one surface or both surfaces of the core member made of aluminum or an aluminum alloy with the low melting point aluminum alloy group solder material for the heat dissipation board of FIG. 18, higher reliable bonding can be attained.

When the semiconductor power element heat dissipation board according to the present invention is applied to a power module, the semiconductor power element is bonded onto the conductor plate 6 or 20 by solder though this has not been illustrated in the figure.

According to the present invention, there is the remarkable effect of obtaining a semiconductor power element heat dissipation board which has a high bonding strength without voids in the bonding portion, and has high reliability without forming a thick brittle Al/Cu intermetallic chemical compound, and of which the manufacturing method is simple, and to provide a conductor plate and a heat sink plate and a solder used for the semiconductor power element heat dissipation board, and to provide a power module and a composite plate using the semiconductor power element heat dissipation board.

## Claims

1. A semiconductor power element heat dissipation board formed by successively laminating a conductor plate, a ceramic plate and a first heat sink plate, or a conductor plate, a ceramic plate, a first heat sink plate and a second heat sink plate, wherein at least one pair of said conductor plate and said ceramic plate, said ceramic plate and said first heat sink plate, and said first heat sink plate and said second heat sink plate are bonded to each other by an aluminum alloy group solder, and a strength of the bonding is higher than 10 MPa.

2. A semiconductor power element heat dissipation board formed by successively laminating a conductor plate, a ceramic plate and a first heat sink plate, or a conductor plate, a ceramic plate, a first heat sink plate and a second heat sink plate, wherein at least one pair of said conductor plate and said ceramic plate, said ceramic plate and said first heat sink plate, and said first heat sink plate and said second heat sink plate are bonded to each other using a composite solder material having a solder material formed on one surface or both surfaces of a core member or a conductor plate made of aluminum or an aluminum alloy group solder.

3. A semiconductor power element heat dissipation board formed by successively laminating a conductor plate, a ceramic plate and a first heat sink plate, or a conductor plate, a ceramic plate, a first heat sink plate and a second heat sink plate, wherein at least one pair of said conductor plate and said ceramic plate, said ceramic plate and said first heat sink plate, and a diffusion suppression member for suppressing diffusion of aluminum in said solder material to said conductor plate and said heat sink plate is provided at least one side between said conductor plate and said ceramic plate, between said ceramic plate and said first heat sink plate, and between said first heat sink plate and said second heat sink plate.

4. A semiconductor power element heat dissipation board formed by successively laminating a conductor plate, a ceramic plate and a first heat sink plate, or a conductor plate, a ceramic plate, a first heat sink plate and a second heat sink plate, wherein at least one pair of said conductor plate and said ceramic plate, said ceramic plate and said first heat sink plate, and said first heat sink plate and said second heat sink plate are bonded to each other by an aluminum alloy group solder having a melting point lower than 500 °C.

5. A semiconductor power element heat dissipation board formed by successively laminating a conductor plate, a ceramic plate and a first heat sink plate, or a conductor plate, a ceramic plate, a first heat sink plate and a second heat sink plate, wherein at least one pair of said conductor plate and said ceramic plate, said ceramic plate and said first heat sink plate, and said first heat sink plate and said second heat sink plate are bonded to each other by an aluminum alloy group solder made of an Al alloy containing any one of Ge of 40 to 60 %, Mg of 30 to 70 %, Ga of 52 to 85 %, Li of 48 to 75 %, Sn of 93 to 98 %, Zn of 75 to 95 %, and Sn and Zn of 75 to 98 % in total, in weight percentage.

6. A semiconductor power element heat dissipation board according to any one of claims 1 to 5, wherein nickel is plated on outer surfaces of said conductor plate and said heat sink plate.

7. A semiconductor power element heat dissipation board according to any one of claims 1 to 5, wherein nickel is plated on one surface or both surfaces of said conductor plate and on one surface or both surfaces of said heat sink plate.

8. A conductor plate for semiconductor power element heat dissipation board, which is formed in a one-piece structure by providing any one of a diffusion suppression member for suppressing diffusion with aluminum, an aluminum alloy group solder having a melting point lower than 500 °C, and a composite solder having an aluminum alloy group solder formed on one surface or on the both surfaces of a core member or a conductor plate made of aluminum or an aluminum alloy on one surface or on the both surfaces of a conductor plate made of copper or a copper alloy.

9. A conductor plate for semiconductor power element heat dissipation board, which is formed in a one-piece structure by bonding a composite solder having an aluminum alloy group solder formed on one surface or on the both surfaces of a core member or a conductor plate made of aluminum or an aluminum alloy onto one surface or onto both surfaces of a ceramic plate by said aluminum alloy group solder.

10. A conductor plate for semiconductor power element heat dissipation board, which is formed in a one-piece structure by providing a nickel plated film on one surface of a conductor plate made of copper or a copper alloy, and providing any one of a diffusion suppression member for suppressing diffusion to aluminum, an aluminum alloy group solder having a melting point lower than 500 °C and a composite solder having an aluminum alloy group solder formed on one surface or on the both surfaces of a core member or a conductor plate made of aluminum or an aluminum alloy on the other surface of the conductor plate made of copper or a copper alloy.

11. A conductor plate for semiconductor power element heat dissipation board, which comprises a conductor plate made of copper or a copper alloy has a nickel plated film on one surface, a diffusion suppression member for suppressing diffusion to aluminum on the other surface, and a conductor plate made of aluminum or an aluminum alloy on a surface of said diffusion suppression member.

12. A conductor plate for semiconductor power element heat dissipation board, which is a composite conductor plate having an aluminum alloy group solder formed on a conductor plate made of copper or a copper alloy through a core member or a conductor plate made of aluminum or an aluminum alloy in a one-piece structure, and a diffusion suppression member for suppressing diffusion of aluminum in said solder to the conductor plate made of copper or a copper alloy is provided between said conductor plate made of copper or a copper alloy and said core member or said conductor plate made of aluminum or an aluminum alloy.

13. A heat sink for semiconductor power element, wherein a diffusion suppression member for suppressing diffusion of aluminum is provided on a surface of a heat sink plate.

14. A solder, which is made of a material selected from the group consisting of an Al-Ga alloy, an Al-Li alloy, an Al-Sn alloy, an Al-Zn alloy, an Al-Sn-Zn alloy, an Al-Mg alloy, an Al-Si-Mg alloy, an Al-Ge alloy and an Al-Si-Ge alloy, and has a melting point lower than 500 °C.

15. A composite solder, which comprises a core member made of aluminum or an aluminum alloy and a solder on one surface or on the both surfaces of said core member, and said solder is made of a material selected from the group consisting of an Al-Ga alloy, an Al-Li alloy, an Al-Sn alloy, an Al-Zn alloy, an Al-Sn-Zn alloy, an Al-Mg alloy, an Al-Si-Mg alloy, an Al-Ge alloy and an Al-Si-Ge alloy and has a melting point lower than 500 °C.

16. A composite solder for semiconductor power element heat dissipation board, wherein an aluminum alloy group solder portion is formed on one surface or on the both surfaces of a core member made of aluminum or an aluminum alloy.

17. A power module comprising a semiconductor power element heat dissipation board formed by successively laminating a conductor plate, a ceramic plate and a heat sink plate, and a semiconductor power element bonded to said conductor plate, wherein said heat dissipation board is the heat dissipation board according to any one of claims 1 to 7, or said conductor plate is the conductor plate according to any one of claims 8 to 12.

18. A composite plate, which is formed in a one-piece structure by bonding a metallic plate and a ceramic plate through a diffusion suppression member for suppressing diffusion of aluminum using an aluminum alloy group solder having a melting point lower than 500 °C or using a composite solder having an aluminum alloy group solder formed on one surface or on the both surfaces of a core member or a conductor plate made of aluminum or an aluminum alloy, said diffusion suppression member being provided in said metallic plate.

19. A semiconductor power element heat dissipation board according to claim 3, wherein said diffusion suppression member is made of a material selected from the group consisting of pure Ni, pure Cr, pure Ti, pure W, an Ni alloy, a Cr alloy, a Ti alloy and a W alloy.

20. A conductor plate for semiconductor power element heat dissipation board according to any one of claim 8 and claims 10 to 12, wherein said diffusion suppression member is formed of a material selected from the group consisting of pure Ni, pure Cr, pure Ti, pure W, an Ni alloy, a Cr alloy, a Ti alloy and a W alloy.

21. A semiconductor power element heat dissipation board according to any one of claims 1 to 7, wherein after successively laminating said conductor plate, said ceramic plate and said first heat sink plate, or said conductor plate, said ceramic plate, said first heat sink plate and said second heat sink plate, these plates are bonded under a vacuum atmosphere or an inert atmosphere using an aluminum alloy group solder while the laminated body is being heated and added with a load.
